(19) Europäisches Patentamt
European Patent Office
Office européen des brevets

(11) **EP 2 203 752 B1**

(12) **FASCICULE DE BREVET EUROPEEN**

(45) Date de publication et mention
de la délivrance du brevet:
**26.06.2013 Bulletin 2013/26**

(51) Int Cl.:
*G01R 31/302* *(2006.01)*          *G01R 31/28* *(2006.01)*
*G01R 31/308* *(2006.01)*          *G01R 31/3183* *(2006.01)*
*G01R 31/3181* *(2006.01)*          *G01R 31/00* *(2006.01)*

(21) Numéro de dépôt: **08843897.3**

(22) Date de dépôt: **23.10.2008**

(86) Numéro de dépôt international:
**PCT/FR2008/051913**

(87) Numéro de publication internationale:
**WO 2009/056738 (07.05.2009 Gazette 2009/19)**

(54) **PROCÉDÉ DE DÉTERMINATION DE LA SENSIBILITÉ DES COMPOSANTS ÉLECTRONIQUES VIS-À-VIS DES PARTICULES**

**VERFAHREN ZUR BESTIMMUNG DER PARTIKELEMPFINDLICHKEIT ELEKTRONISCHER KOMPONENTEN**

**METHOD OF DETERMINING THE PARTICLE SENSITIVITY OF ELECTRONIC COMPONENTS**

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **26.10.2007 FR 0758621**

(43) Date de publication de la demande:
**07.07.2010 Bulletin 2010/27**

(73) Titulaires:
• **European Aeronautic Defence And Space Company EADS**
**75116 Paris (FR)**
• **Airbus Operations**
**31060 Toulouse Cédex (FR)**
• **ASTRIUM SAS**
**75016 Paris (FR)**

(72) Inventeurs:
• **MILLER, Florent**
**F-92300 Levallois (FR)**
• **BUARD, Nadine**
**F-92190 Meudon (FR)**
• **WEULERSSE, Cécile**
**F-78000 Versailles (FR)**
• **CARRIERE, Thierry**
**F-78510 Triel Sur Seine (FR)**
• **HEINS, Patrick**
**F-81140 Castelnau de Montmiral (FR)**

(74) Mandataire: **Deschamps, Samuel**
**Cabinet Schmit-Chretien**
**16 rue de la Paix**
**75002 Paris (FR)**

(56) Documents cités:
**EP-A- 0 180 780**          **EP-A- 1 231 551**
**WO-A-2007/119030**      **US-A- 4 786 865**
**US-A- 4 878 179**          **US-A1- 2006 049 843**

• LERAY J-L ET AL: "Atmospheric neutron effects in advanced microelectronics, standards and applications" INTEGRATED CIRCUIT DESIGN AND TECHNOLOGY, 2004. ICICDT '04. INTERNATIO NAL CONFERENCE ON AUSTIN, TX, USA 17-20 MAY 2004, PISCATAWAY, NJ, USA, IEEE, US, 17 mai 2004 (2004-05-17), pages 311-321, XP010726265 ISBN: 978-0-7803-8528-3
• ANN GARRISON DARRIN M ET AL: "The Impact of the Space Radiation Environment on Micro Electro Mechanical Systems (MEMS) and Microstructures" RADIATION AND ITS EFFECTS ON COMPONENTS AND SYSTEMSM, 2005. RADECS 200 5. 8TH EUROPEAN CONFERENCE ON, IEEE, PI, 1 septembre 2005 (2005-09-01), pages H1-1, XP031152666 ISBN: 978-0-7803-9501-5
• BONANOMI M ET AL: "A Model for TID Effects on Floating Gate Memory Cells" IEEE TRANSACTIONS ON NUCLEAR SCIENCE, IEEE SERVICE CENTER, NEW YORK, NY, US, vol. 51, no. 6, 1 décembre 2004 (2004-12-01), pages 3753-3758, XP011123948 ISSN: 0018-9499

## Description

*Domaine de l'invention*

Le but de l'invention est de déterminer la sensibilité des composants électroniques vis-à-vis des particules de type ions lourds, neutrons et protons, en mettant en oeuvre l'utilisation conjointe d'un système laser et d'un code de prédiction de défaillance basé sur la physique de l'interaction particule/matière.

*Etat de la technique*

Les environnements radiatifs naturels ou artificiels (neutrons, protons, ions lourds, flash X, rayons gamma) peuvent perturber le fonctionnement des composants électroniques. Ces perturbations sont dues à des interactions entre la matière et les particules de l'environnement radiatif. Une des conséquences est la création de courants parasites dans le composant. Selon l'endroit où ont lieu les interactions entre la matière et les particules, les courants parasites produits seront plus ou moins importants. Ceci traduit la présence de zones localisées de collection de charges dans le composant.

De telles agressions par des ions lourds et des protons sont typiquement rencontrées, dans l'espace, par des satellites et des lanceurs. A des altitudes moins élevées où évoluent des avions, on note surtout la présence d'agressions par des neutrons. Au niveau de la mer, de telles agressions peuvent aussi être rencontrées et affecter les composants électroniques embarqués dans des appareils portables, ou dans des voitures.

Pour pouvoir prédire le comportement des composants vis à vis des ions lourds, des neutrons et des protons, notamment pour des applications spatiales ou aéronautiques, il est nécessaire de connaître l'étendue surfacique des zones de collection de charges ainsi que leur position et dimension en profondeur, ce qui suppose de pouvoir établir des cartographies à trois dimensions.

Classiquement, pour évaluer la sensibilité d'un composant électronique aux particules de l'environnement radiatif, le composant est soumis à un flux de particules et les perturbations sont comptabilisées. Dans la mesure où tout le composant est irradié, ce type de test ne permet pas de remonter à la localisation des zones de collection de charges. De plus, ces tests sont relativement onéreux car il y a relativement peu d'installations dans le monde susceptibles de produire des flux de particules. Enfin, même si la nature des particules issues des accélérateurs de particules est la même que celle de l'environnement radiatif, leur énergie peut être différente. Ceci peut conduire à d'importantes erreurs, en particulier à cause de leur plus faible pénétration dans le composant.

Des faisceaux de petites tailles peuvent être extraits de la sortie d'accélérateur de particules. Il est alors possible d'utiliser ces micro faisceaux pour cartographier les zones de sensibilités d'un composant. Cette cartographie s'effectue dans un plan et ne permet de révéler que de manière surfacique la localisation des zones de collection de charges. Aucune information sur la localisation en profondeur de la zone sensible n'est obtenue par ce type de test.

Jusqu'à maintenant, le laser était principalement utilisé comme un outil de pré-caractérisation de la sensibilité des composants aux radiations. Tout comme les particules de l'environnement radiatif, le laser peut, lorsque sa longueur d'onde est appropriée, générer des courants parasites à l'intérieur des composants.

On connaît dans l'état de la technique :

- La demande de brevet PCT N° WO 2007/119030 (EADS) ; et
- La demande de brevet européen N° EP 1 231 551 (Infineon Technologies).

Le laser présente un avantage très intéressant pour l'étude de l'effet des radiations. Dans la mesure où la résolution spatiale du laser peut atteindre des dimensions relativement faibles par rapport aux structures élémentaires contenues dans les composants électroniques, il est possible, tout comme dans le cas du micro faisceau, de cartographier un composant électronique et d'identifier ses zones de collection de charges. En variant le point de focalisation en profondeur du faisceau, la cartographie de sensibilité peut également être faite dans la troisième dimension, et ce de façon aisée industriellement. Mais cette connaissance n'est pas suffisante pour connaître le comportement global du composant électronique vis-à-vis des radiations.

*Exposé de l'invention*

Dans l'invention, pour remédier à ce problème, on a eu l'idée de procéder par simulation. Une fois la carte de sensibilité du composant acquise, celle-ci se présente sous la forme d'un modèle, une matrice en pratique, à quatre ou cinq dimensions, en X Y Z et coefficient de sensibilité ou en X Y Z T et coefficient de sensibilité. On soumet alors ce modèle de ce composant, à une agression simulée et on mesure sa réponse simulée. Par exemple schématiquement, si à un instant T donné, un ion simulé (qu'il s'agisse d'un ion primaire ou produit d'une réaction nucléaire) passe au travers d'une zone élémentaire de coordonnées XYZ, et si, à cet instant, la zone élémentaire concernée a une sensibilité s, on attribue au composant la valeur de qualité s. Puis on réitère l'expérience pour un autre ion simulé. Ainsi de suite, sur une durée d'étude donnée alors que le cas échéant, le temps varie et que l'application mise en service par le composant se déroule, on collecte les valeurs s, puis, par exemple à l'issue d'une durée donnée de mesure, on compile les valeurs de qualité mesurées pour connaître la qualité réelle du composant. En agissant ainsi, plutôt que de disposer d'une cartographie soumise à conjecture, on obtient une véritable mesure de cette qualité.

Selon l'invention, la connaissance fournie par les cartographies laser et relative à la position et à la profondeur des zones de sensibilité d'un composant électronique peut être utilisée en tant que paramètre d'entrée dans des codes de prédiction pour quantifier la sensibilité du composant électronique cartographié vis-à-vis des particules ionisantes de l'environnement radiatif naturel. Les codes de prédiction permettent d'évaluer l'occurrence des dysfonctionnements dans un composant électronique. L'évaluation des risques liés à l'environnement radiatif impose deux aspects : l'un, probabiliste, prend en compte l'interaction particule/matière, l'autre, électrique, prend en compte la collection de charges à l'intérieur du composant électronique.

Avec cette méthode on détermine la sensibilité de composants électroniques vis à vis des radiations à partir des tests laser : les informations sur la géométrie des zones de collection de charges du composant servent alors de paramètres d'entrée dans des simulations de prédiction d'erreur vis à vis des particules (ions lourds, neutrons, protons...). La méthode de l'invention permet de mettre en évidence les faiblesses d'une technologie pour la tenue aux radiations, ce qui est une information importante pour le développement des nouveaux composants en ce qui concerne leur procédé de fabrication et pour le choix des composants électroniques à utiliser dans les systèmes électroniques pour qu'ils présentent les sensibilités les plus faibles. Dans l'invention, dans le cas de l'étude de la sensibilité aux neutrons et aux protons, plutôt que de se lancer dans des simulations exhaustives des réactions nucléaires avec les noyaux constitutifs des composants électroniques, on préfère utiliser une base de données préalablement construite qui, pour une énergie d'agression d'une particule incidente donnée, donne les caractéristiques des produits issus des réactions ainsi que les probabilités associées à chacune des réactions possibles. Dans le cas des ions lourds, les réactions nucléaires ne sont pas étudiées et il n'existe pas de base de données car les ions lourds ont directement un fort pouvoir ionisant. Le code de simulation permet d'évaluer, à partir de critères, l'effet qu'aurait eu l'interaction de ces particules sur le fonctionnement du composant électronique.

L'invention a donc pour objet un procédé de caractérisation de la sensibilité aux interactions énergétiques d'un composant électronique dans lequel,

- on met le composant électronique en service,
- on excite le composant électronique ainsi mis en service par des excitations produites par un rayonnement laser,
- on mesure un défaut de fonctionnement du composant électronique mis en service correspondant à ces excitations,
- on établit une cartographie de zones de sensibilité du composant où ces excitations ont un effet,
- on applique à la cartographie de zones de sensibilité un programme de simulation d'agression par une particule provoquant des interactions énergétiques,
- ce programme de simulation produit un grand nombre de parcours possibles des particules dans le composant, et dans le cas de neutrons et de protons, un grand nombre de réactions nucléaires extraites d'une base de données,
- ce programme de simulation, met en oeuvre, à partir de ces parcours possibles et de la cartographie de la sensibilité du composant un modèle de collection de charges,
- ce programme de simulation analyse ces collections de charges et statue sur l'occurrence d'erreurs liées à ces collections de charges,
- le signal de qualité du composant est déduit de cette analyse et de ces statuts.

Avantageusement l'invention est également caractérisée en ce que

- on utilise, dans le cas des neutrons et des protons, une base de données renseignant sur des produits et des probabilités de réactions nucléaires possibles et
- on mesure l'effet de l'ionisation sur le fonctionnement du composant électronique.

Avantageusement l'invention est également caractérisée en ce que

- on applique un traitement à la cartographie laser établie pour extraire une cartographie utile, cette cartographie utile rendant compte de la sensibilité du composant aux particules ionisantes.

Avantageusement l'invention est également caractérisée en ce que

- on réalise une déconvolution mathématique pour prendre en considération une taille d'un impact laser par rapport à une taille estimée d'une zone de sensibilité du composant vis-à-vis de particules ionisantes.

Avantageusement l'invention est également caractérisée en ce que

- pour des composants avec intégration fine on mesure avec la cartographie laser une taille maximale de zone de sensibilité d'une cellule élémentaire.

Avantageusement l'invention est également caractérisée en ce que

- pour quantifier la sensibilité du composant, on simule à l'aide du programme de simulation une réponse du composant électronique aux excitations suivant des critères déterminés pour le dysfonctionnement étudié.

Avantageusement l'invention est également caractérisée en ce que

- le programme de simulation choisit des réactions nucléaires dans une base de données correspondant au type et à l'énergie de la particule étudiée.

Avantageusement l'invention est également caractérisée en ce que

- à titre de mesure d'interaction énergétique on mesure, par simulation laser, des interactions d'ions lourds et ou de protons et ou de neutrons.

Avantageusement l'invention est également caractérisée en ce que

- l'énergie du photon laser de la source laser est supérieure à la valeur de la bande interdite du composant semi-conducteur.

Avantageusement l'invention est également caractérisée en ce que

- la source laser provoque une absorption simultanée de plusieurs photons dans le matériau semi conducteur.

Avantageusement l'invention est également caractérisée en ce que

- la cartographie laser est réalisée selon les trois dimensions de l'espace.

Avantageusement l'invention est également caractérisée en ce que

- la cartographie laser est réalisée selon quatre dimensions, les trois dimensions de l'espace ainsi que le temps.

L'invention a également pour objet un dispositif comportant des moyens aptes à mettre en oeuvre le procédé de détermination de la sensibilité des composants électroniques vis-à-vis des particules, de l'invention.

*Brèves description des figures*

L'invention sera mieux comprise à la lecture de la description qui suit et à l'examen des figures qui l'accompagnent. Celles-ci ne sont données qu'à titre indicatif et nullement limitatif de l'invention. Les figures montrent :

- Figures 1 a à 1 c, trois différents cas d'étude permettant de distinguer l'efficacité de l'agression suivant un niveau d'intégration du composant;
- Figure 2 : le contenu symbolique d'une base de donnée qui détaille les produits créés lors d'une réaction nucléaire pour une particule incidente d'une énergie donnée et la probabilité associée à cette réaction.
- Figure 3 : le principe général d'un code Monte-Carlo pour la prédiction de sensibilité de composants électroniques;
- Figures 4a et 4b : la représentation temporelle de la collection des porteurs déposés par le passage d'un ion et le principe d'un critère (Imax, tlmax) de SEU pour une technologie de 0,6μm.

*Description détaillée de modes de réalisation de l'invention*

Selon l'invention, un dispositif laser permet, préalablement, de mettre un composant électronique à tester en service, de l'exciter par des excitations produites par un rayonnement laser, et de mesurer un défaut de fonctionnement du composant électronique mis en service correspondant à ces excitations. Ce dispositif permet ainsi d'établir une cartographie de zones de sensibilité du composant où ces excitations ont un effet. Dans un exemple, la source laser provoque une absorption de photons dans le matériau semi conducteur du composant.

La présente invention est ensuite basée sur l'utilisation conjointe d'un tel système laser et d'un code de prédiction pour calculer la sensibilité d'un composant électronique vis-à-vis de l'environnement radiatif naturel. Le laser est utilisé pour cartographier la sensibilité du composant vis-à-vis de l'injection localisée de charges. Un critère est observé. Ce dernier permet de rendre compte de l'évènement étudié. Il peut s'agir d'un signal électrique qui lorsque l'événement se déclenche est différent du signal attendu. Dans le cas d'un composant logique comme une mémoire, il peut s'agir de la valeur stockée dans une cellule mémoire. Pour un composant linéaire, il peut s'agir d'un signal analogique du composant.

Le système comprend :

- une source laser dont la longueur d'onde permet la génération de charges dans le matériau semi conducteur considéré (par mécanisme d'absorption linéaire ou non linéaire);
- un dispositif permettant le déplacement relatif du laser par rapport au composant sous test suivant les trois directions de l'espace;
- éventuellement, une interface permettant la communication entre le composant sous test et le système de contrôle du laser;
- un dispositif de modification de l'énergie laser;
- un dispositif permettant d'établir si un événement a eu lieu ou non.

Une cartographie de sensibilité du composant est effectuée selon les trois dimensions de l'espace. Elle peut également tenir compte du temps, ce qui rajoute une autre dimension. Pour chaque position X, Y, Z de la cartographie et le cas échéant pour chaque instant t du cycle de fonctionnement du composant ou de l'application exécutée par ce composant, un tir laser est effectué. Ce tir laser provoque la génération de charges au sein du matériau semi-conducteur. Sous l'influence notamment des champs électriques et des mécanismes de diffusion, les charges se mettent en mouvement et créent des courants qui peuvent perturber le fonctionnement du composant électronique. Toutes les positions (spatiales et temporelles) de la cartographie n'auront pas la même sensibilité car spatialement, les paramètres physiques du composant ne sont pas les mêmes suivants la position, et temporellement, toutes les zones du composant ne sont pas sollicitées de la même façon au cours du temps. La cartographie laser permet de révéler les zones de sensibilité d'un composant à une génération localisée de charges, c'est-à-dire, de mettre en évidence les variations de sensibilité spatiale et éventuellement temporelle. Ce sont ces zones qui seront sensibles à des particules ionisantes (directement ou indirectement) comme les ions lourds, les neutrons et les protons.

Une cartographie laser permet notamment d'identifier :

1 - la position spatiale X, Y, Z d'une zone de sensibilité;
2 - la position temporelle d'une zone de sensibilité, c'est-à-dire les instants où une zone apparaît comme sensible à l'injection de charge;
3 - la forme et le volume de cette zone de sensibilité (qui évoluent le cas échéant en fonction du temps);
4 - la position relative de cette zone de sensibilité par rapport aux zones de sensibilité voisines;
5 - dans le cas des composants logiques et s'il y a lieu, la fonction logique impactée lors d'une injection de charges dans la zone de sensibilité.

Les informations 4 et 5 extraites de la cartographie laser dépendent de la technologie, des conditions d'utilisation, le cas échéant de l'application opérée par le composant. Elles ne dépendent par contre pas de l'allure du dépôt de charge et sont donc valables quel que soit le dépôt de charge considéré (particules ou laser par exemple). Les informations 1, 2 et 3 extraites de la cartographie laser dépendent de la technologie, des conditions d'utilisation, le cas échéant de l'application opérée par le composant. Elles dépendent aussi de l'allure temporelle (pour 2) et spatiale (pour 1 et 3) du dépôt de charge. Dans le cas de 2, il existe des lasers ayant des durées d'impulsions équivalentes à la durée du dépôt de charges d'une particule ionisante dans un matériau semi conducteur (proche de la picoseconde) et dans ce cas, les informations obtenues sont valables quelque soit le dépôt de charge considéré (particules ou laser par exemple).

Ainsi, les cartographies laser permettent d'obtenir deux types différents d'informations. Dans le premier cas, la cartographie laser peut être directement exploitée pour extraire des données sur la sensibilité des composants électroniques vis-à-vis des particules de l'environnement radiatif, cas 4 et 5.

Dans le second cas, cas 1, 2 et 3, il est nécessaire d'appliquer un traitement à la cartographie laser pour extraire des informations utiles pour estimer la sensibilité des composants électroniques vis-à-vis des particules, traitement qui prend en compte la spécificité de l'interaction particule/matière.

En ce qui concerne l'exploitation directe des cartographies laser, cas 4 et 5, le laser va permettre d'identifier les positions relatives des zones de sensibilité (et en fonction du temps ou non). La précision de cette information n'est pas liée à la taille du spot mais à la taille du pas de déplacement utilisé pour réaliser la cartographie laser. En ce sens, l'obtention de cette information de distance interzones sensibles est indépendante de la taille du faisceau considéré.

Pour les composants les plus intégrés possédant un arrangement périodique très fin de cellules élémentaires (comme les mémoires), l'information géométrique de la distance entre une cellule et ses plus proches voisines obtenue grâce à la cartographie laser permet également de donner la taille maximale de la zone de sensibilité d'une cellule élémentaire (toute la cellule étant vue comme sensible). Cette information est obtenue directement et peut être exploitée sans traitement.

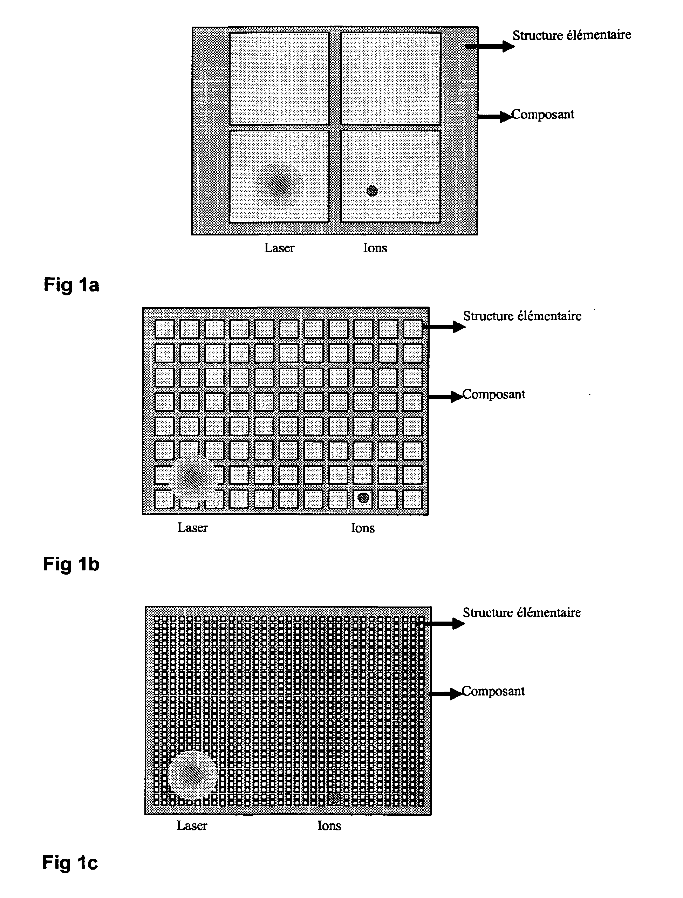

En ce qui concerne le traitement des cartographies laser, dans le second cas identifié 1, 2 et 3, il est nécessaire d'appliquer un traitement à la cartographie laser pour extraire des informations utiles pour estimer la sensibilité des composants électroniques vis-à-vis des particules de l'environnement radiatif. Il convient alors de distinguer trois différents cas d'études suivant le niveau d'intégration du composant. Ces trois cas sont expliqués en regard des figures 1 a à 1 c.

Cas A : Composants peu intégrés pour lesquels la trace d'ionisation du laser et la trace d'ionisation d'un ion d'énergie donnée sont de taille inférieure aux dimensions caractéristiques des structures élémentaires et/ou aux zones de sensibilité du composant électronique.

Cas B : Composants intégrés pour lesquels la trace d'ionisation du laser est de taille supérieure aux dimensions caractéristiques des structures élémentaires ou aux zones de sensibilité du composant électronique alors que la trace d'ionisation d'un ion d'énergie donnée est de taille petite en regard de ces structures.

Cas C : Composants très intégrés pour lesquels la trace d'ionisation du laser et la trace d'ionisation d'un ion d'énergie donnée sont de taille supérieure aux dimensions caractéristiques des structures élémentaires ou aux zones de sensibilité du composant électronique.

Dans chacun des cas, il est possible de traiter les données pour connaître la zone de sensibilité vis-à-vis des particules ionisantes (qu'il s'agisse d'une ionisation directe ou indirecte).

Dans le premier cas A, le dépôt de charge obtenu par un laser focalisé et le dépôt de charges obtenu par un ion sont très localisés par rapport aux structures élémentaires du composant. Les zones identifiées comme sensibles par le laser le seront aussi pour les ions. La cartographie laser permet donc dans ce cas d'identifier directement spatialement et ou temporellement les zones qui sont sensibles au passage d'une particule ionisante (directement ou indirectement).

Dans le second cas B, le laser va surestimer la taille de la zone de sensibilité par rapport à ce qui serait détecté comme sensible par un ion. Autrement dit, la zone de sensibilité détectée par le laser apparaît comme une convolution de la zone de sensibilité réelle du composant avec la taille de la trace d'ionisation générée par le laser. On procède alors à une déconvolution mathématique qui permet de prendre en considération la taille du spot laser pour extraire à partir d'une cartographie laser la taille estimée de la zone de sensibilité du composant vis-à-vis des particules ionisantes. La déconvolution mathématique consiste à retrouver la zone de sensibilité réelle du composant connaissant la zone de sensibilité détectée par le laser et la forme et la taille de la trace d'ionisation du laser. Du point de vue mathématique ceci peut se traduire par la résolution de l'équation suivante :

$$ZSlaser = f(ZSi)$$

Où : ZSlaser est la zone de sensibilité identifiée par le laser, ZSi est la zone de sensibilité du composant vis-à-vis des particules, et f est une fonction de la trace d'ionisation du laser.

La résolution de l'équation consiste à trouver la fonction $f^{-1}$ de sorte que l'on puisse déterminer : $ZSi = f^{-1}$ (ZSlaser).

Dans le troisième cas C, que le dépôt de charges soit dû à un ion ou à un laser, celui-ci a une taille plus importante que la taille de la structure élémentaire du composant. Du point de vue de cette structure élémentaire, le dépôt de charge dû à un ion ou à un laser est quasiment le même car des charges sont créées dans toute la structure élémentaire. La corrélation est, dans ce cas, simple à faire pour passer des informations de sensibilité obtenues au laser vers des informations de sensibilité attendues vis-à-vis des particules ionisantes puisque toute la structure élémentaire est dans ce cas sensible. Les zones de sensibilité associées aux structures élémentaires et détectées par le laser et par l'ion sont directement liées à la taille des traces d'ionisation respectivement, du laser et de l'ion.

La détermination de la localisation des zones de sensibilité en profondeur se fait en faisant varier le point de focalisation du faisceau laser, soit en en changeant la focale, soit en déplaçant le laser focalisé en profondeur par rapport au composant.

Ainsi, le laser permet de remonter à des informations géométriques concernant la position et la taille des zones de sensibilité des composants électroniques vis-à-vis des particules ionisantes. Selon le cas, cas B, il y aura retraitement ou non. Par la suite, pour quantifier la sensibilité des composants électroniques vis-à-vis des particules ionisantes, il est nécessaire, de coupler ces informations géométriques avec un code de prédiction tel que celui décrit ci-après.

Dans le but d'évaluer la sensibilité d'un composant électronique donné dans un environnement radiatif donné (environnement spatial ou avionique), de nombreux outils de prédiction ont été développés, dont SMC DASIE (Simplified Monte Carlo Detailed Analysis of Secondary Ion Effects). Cette méthode a été décrite dans "A review of DASIE codes family : contribution to SEU/MBU understanding" par G. Hubert et AI publié dans «11th IEEE International On-Line Testing Symposium » en 2005. Les différentes versions de ce code sont basées sur le même principe, l'exploitation des bases de données nucléaires, couplées avec des modèles de collection de charges et des critères de déclenchement des effets. Le laser permet d'extraire les données de procédé et de sensibilité à l'injection de charges localisée pour un composant particulier de technologie inconnue au départ. Ces outils de calcul Monte-Carlo reposent sur le tirage aléatoire d'un grand nombre d'interactions reproduisant les conditions de traces ionisantes possibles consécutives à l'interaction ions lourds ou aux réactions nucléaires neutron ou proton avec les noyaux constituant le composant. Ils calculent donc la fréquence des erreurs (SER, Single Event Rate).

Certains codes de prédiction Monte-Carlo permettent de tenir compte d'un grand nombre de cellules élémentaires et donc de traiter la problématique des effets multiples qui apparaissent simultanément dans différentes cellules du composant.

La mise en place d'une méthode Monte-Carlo consiste à gérer trois problématiques :

1 - Gestion du tirage Monte-Carlo des interactions en fonction de l'environnement considéré;
2 - Physique de l'interaction particule/matière (base(s) de données) : connaissance des caractéristiques des ions primaires ou des ions secondaires produits par les réactions neutron ou proton avec les noyaux constituant le composant;
3 - Critère d'erreur : détermination de la collection des charges et de leur conséquence.

Pour étudier les effets singuliers induits dans les composants électroniques par les neutrons atmosphériques ou les protons des ceintures de radiations, il est nécessaire de connaître les produits ionisants (appelés ions secondaires, noyaux de recul, fragments ou produits de spallation) que ces nucléons provoquent avec les atomes de la cible.

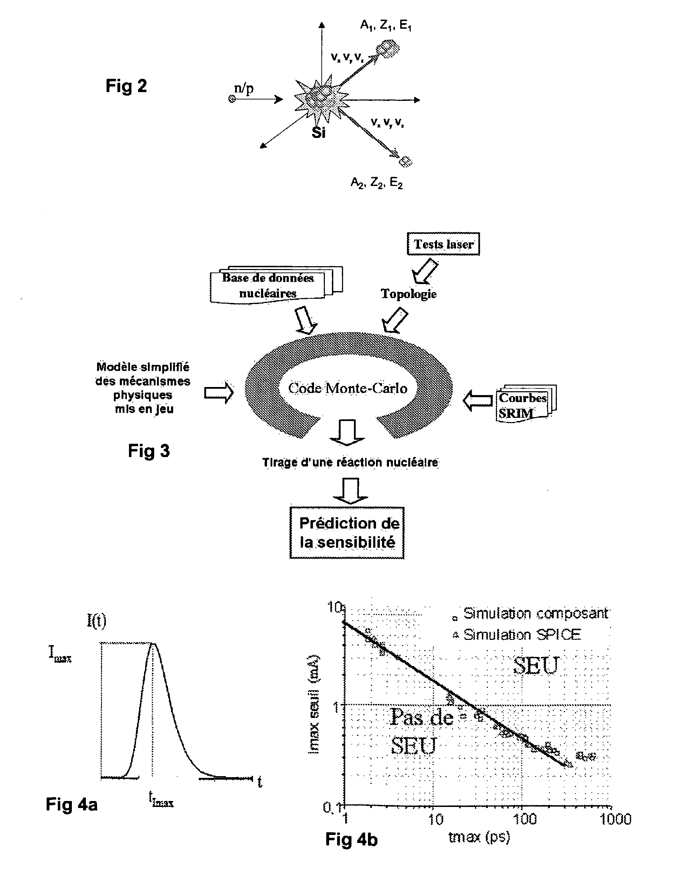

Compte tenu de l'étendue énergétique (de 1 MeV à 1 GeV) des différents types d'interaction (élastique, non-élastique, etc.), différents codes ont été utilisés pour la génération des bases de données afin de décrire les différents mécanismes d'interaction selon leurs spécificités, i.e. types de réactions et énergies. Des codes de calcul dédiés comme HETC, MC-RED, MC-Recoil, GEANT4, GNASH, ou MCNP (selon l'énergie de la particule incidente) ou des bases de données des interactions comme ENDF ou JENDL peuvent être utilisés. La plupart de ces codes nucléaires sont accessibles via Internet. Le principe de l'interaction d'un neutron n, ou d'un proton p avec un noyau cible est symbolisé sur la figure 2.

Pour les énergies neutron/proton inférieures à 10 MeV, les réactions élastiques sont prépondérantes. A l'inverse, pour les énergies supérieures à 50 MeV, les réactions de type non-élastiques sont majoritaires. Les réactions de type élastique sont celles qui induisent une perte d'énergie du n/p incident et un ion de recul (conservation de l'énergie cinétique et du nombre de masse). Les réactions non-élastiques sont variées, chaque réaction se caractérise par un seuil énergétique d'apparition. Ces réactions induisent la génération d'un ou de plusieurs ions secondaires.

Les bases de données traitent les interactions neutron/matière ou proton/matière et se composent, pour chaque énergie incidente, de centaines de milliers d'événements nucléaires non élastiques et élastiques avec le détail des réactions nucléaires, c'est-à-dire, les nombres nucléaires et de masse des ions secondaires, leurs énergies et leurs caractéristiques d'émission (angles d'émission).

Le principe général d'un code Monte-Carlo pour la prédiction de sensibilité de composants électroniques est illustré sur la figure 3. La méthode consiste à réaliser un ensemble de tirages aléatoires de réactions nucléaires associés à un tirage de leur localisation dans le composant. La réalisation de cet ensemble de tirage est assimilée à une durée d'expérience. Pour chacune de ces configurations, une analyse, fondée sur un modèle simplifié de l'étude des mécanismes physiques de collection des charges, permet de statuer sur l'occurrence d'une erreur induite par des ions secondaires ayant telle caractéristique. Dans le cas de l'étude ions lourds, la méthode reste identique mais il n'y a pas de tirage aléatoire des réactions nucléaires, puisque seul est étudié une particule primaire.

Le cas échéant, ces codes de simulation prennent en compte la taille de la trace d'ionisation des particules chargées. Au lieu de déposer la charge en un seul point, une distribution radiale de la charge est introduite.

La simplification du modèle physique est obtenue à partir de l'étude d'un grand nombre de simulations composants. Ces dernières permettent de résoudre, pour une structure donnée et préalablement maillée, les équations du semi-conducteur pour chaque point de maillage de la structure mais également, à chaque instant du domaine temporel étudié. Ces simulations permettent d'étudier de façon très précise le comportement qu'un composant électronique aura vis-à-vis d'une interaction ionisante. Néanmoins, ces simulations sont très couteuses en temps de calcul. Pour cette raison, dans le cadre de l'invention, il est nécessaire de procéder à une simplification de la méthode permettant de simuler les dysfonctionnements étudiés. C'est l'étude préalable d'un grand nombre de simulations composants qui permet d'identifier les paramètres qui influent sur l'apparition de l'erreur et de définir les modèles simplifiés des mécanismes physiques mis en jeu qui seront implémentés dans l'outil de prédiction.

Ainsi, par exemple et sans que cela ne soit limitatif du type de composant auquel l'invention peut s'appliquer, il est notamment connu que dans le cas d'un basculement d'une cellule SRAM, sa sensibilité est caractérisée par le paramètre de LET critique (défini comme la perte d'énergie par unité de parcours) ou de charge critique. Pour qu'une erreur soit provoquée, il faut que l'ion ou les ions générés par la réaction nucléaire déposent suffisamment d'énergie dans les drains des transistors à l'état OFF. Les simulations composants ont montré que les conditions favorables à la création d'une erreur sont que sa trace passe assez près d'une des zones sensibles, ou bien la traverse, afin d'y induire un courant parasite ou une collection de charges suffisants pour créer un basculement. Des modèles simples (notamment analytiques) de diffusion-collection basés sur la diffusion ambipolaire des porteurs et la collection des charges sur les drains bloqués permettent de décrire le déplacement des porteurs.

Différentes méthodes permettant d'évaluer si le dysfonctionnement suite au passage d'un ion a eu lieu ou non, peuvent être utilisées. La première méthode procède par une approche simplifiée (du premier ordre). Elle est fondée sur la détermination de la charge déposée par l'ion dans le volume sensible de la cellule élémentaire et de la comparaison de celle-ci à une valeur seuil de basculement.

La seconde méthode est une étude plus fine du phénomène (de second ordre). Figure 4a, la collection des porteurs déposés par le passage de l'ion est étudiée temporellement afin de reconstruire le courant. L'évolution temporelle du courant permet de déterminer si un basculement se produit ou non. Par exemple, le critère dynamique (Imax, tImax) introduit une courbe frontière séparant les couples (Imax, tImax) induisant des basculements également appelés SEU (Single Event Upset) de ceux qui n'en induisent pas. Partant de l'observation que tous les passages de particules induisent des courants qui ont la même forme i.e. une croissance prompte suivie d'une lente décroissance, chaque passage d'ion peut être caractérisé par le couple amplitude maximale du courant (Imax) et le temps auquel il s'établit (tImax).

La figure 4b montre l'exemple du principe du critère dynamique (Imax, tImax) pour étudier la sensibilité aux SEU pour une technologie de $0,6 \mu m$. Pour mesurer le défaut de fonctionnement du composant, on mesure l'évolution temporelle du courant résultant de l'excitation. Le critère (Imax, tImax) de ce courant permet de statuer sur le basculement de l'état logique du composant.

Les exemples précités sont relatifs à l'étude du mécanisme de SEU dans un point mémoire SRAM mais l'objet de l'invention s'applique à tout type de composant électronique et tout type d'effets induits par les radiations dès lors que le critère de l'effet induit par les radiations est identifié (un même critère pouvant être commun à plusieurs effets induits par les radiations),

En plus de la base de données nucléaire décrite ci-dessus, des courbes sont fournies par un code de calcul décrivant le comportement du dépôt énergétique des ions secondaires ou des ions lourds lors de leurs passages dans le matériau (comme l'outil SRIM accessible via Internet). La base de données et les courbes SRIM sont fixes quelque soit le type d'erreur étudié mais dépendent des matériaux qui constituent le composant électronique. Les entrées technologiques nécessaires au code de calcul sont les informations relatives à la topologie du composant (c'est-à-dire le volume des zones sensibles et la distance entre 2 zones sensibles). Ces paramètres varient suivant le composant et le type d'erreur étudié.

Les entrées nécessaires à la prédiction de sensibilité d'un composant électronique sont : les dimensions d'une cellule élémentaire, la dimension et la position du volume sensible d'une cellule associée au phénomène souhaité et les positions des zones de sensibilité voisines. L'outil laser permet d'obtenir ces informations. Le couplage entre l'outil de prédiction et les cartographies laser permet dès lors de quantifier la sensibilité, la qualité, des composants électroniques. Le traitement éventuel des informations obtenues par les cartographies laser dépend du niveau d'intégration du composant par rapport aux tailles du spot laser et des traces d'ionisation des particules mis en jeux. Ces données géométriques sont utilisées en entrée des codes de prédiction pour quantifier la sensibilité d'un composant électronique vis-à-vis des particules de l'environnement radiatif naturel.

**Revendications**

1. Procédé de caractérisation de la sensibilité aux interactions énergétiques d'un composant électronique, dans lequel:

  - on met le composant électronique en service,
  - on excite le composant électronique ainsi mis en service par des excitations produites par un rayonnement laser,
  - on mesure un défaut de fonctionnement du composant électronique mis en service correspondant à ces excitations,
  - on établit une cartographie de zones de sensibilité du composant où ces excitations ont un effet,
  - on applique à la cartographie de zones de sensibilité un programme de simulation d'agression par une particule provoquant des interactions énergétiques,

  - ce programme de simulation produit un grand nombre de parcours possibles des particules dans le composant, et dans le cas de neutrons et de protons, un grand nombre de réactions nucléaires extraites d'une base de données,
  - ce programme de simulation, met en oeuvre, à partir de ces parcours possibles et de la cartographie de la sensibilité du composant un modèle de collection de charges,
  - ce programme de simulation analyse ces collections de charges et statue sur l'occurrence d'erreurs liées à ces collections de charges, et
  - le signal de qualité du composant est déduit de cette analyse et de ces statuts,

le procédé étant **caractérisé en ce que**:

  - on utilise, dans le cas des neutrons et des protons, une base de données renseignant sur des produits et des probabilités de réactions nucléaires possibles,
  - on mesure l'effet de l'ionisation sur le fonctionnement du composant électronique,
  - pour des composants avec intégration fine, on mesure avec la cartographie laser une taille maximale de zone de sensibilité d'une cellule élémentaire, et
  - le programme de simulation choisit des réactions nucléaires dans une base de données correspondant au type et à l'énergie de la particule étudiée.

2. Procédé selon la revendication 1, **caractérisé en ce que**

  - on applique un traitement à la cartographie laser établie pour extraire une cartographie utile, cette cartographie utile rendant compte de la sensibilité du composant aux particules ionisantes.

3. Procédé selon la revendication 2, **caractérisé en ce que**

  - on réalise une déconvolution mathématique pour prendre en considération une taille d'un impact laser par rapport à une taille estimée d'une zone de sensibilité du composant vis-à-vis de particules ionisantes.

4. Procédé selon l'une des revendications 1 à 3, **caractérisé en ce que**

  - pour quantifier la sensibilité du composant, on simule à l'aide du programme de simulation une réponse du composant électronique aux excitations suivant des critères déterminés pour le dysfonctionnement étudié.

**5.** Procédé selon l'une des revendications 1 à 4, **caractérisé en ce que**

- à titre de mesure d'interaction énergétique on mesure, par simulation laser, des interactions d'ions lourds et ou de protons et ou de neutrons.

**6.** Procédé selon l'une des revendications 1 à 5, **caractérisé en ce que**

- l'énergie du photon laser de la source laser est supérieure à la valeur de la bande interdite du composant semi-conducteur.

**7.** Procédé selon l'une des revendications 1 à 6, **caractérisé en ce que**

- la source laser provoque une absorption simultanée de plusieurs photons dans le matériau semi conducteur.

**8.** Procédé selon l'une des revendications 1 à 7, **caractérisé en ce que**

- la cartographie laser est réalisée selon les trois dimensions de l'espace.

**9.** Procédé selon l'une des revendications 1 à 8, **caractérisé en ce que**

- la cartographie laser est réalisée selon quatre dimensions, les trois dimensions de l'espace ainsi que le temps.


**Patentansprüche**

**1.** Verfahren zur Charakterisierung der Empfindlichkeit eines elektronischen Bauteils bezüglich energetischer Wechselwirkungen, bei dem

- man das elektronische Bauteil in Betrieb nimmt,
- man das in Betrieb genommene elektronische Bauteil durch Anregungen erregt, die durch eine Laserstrahlung erzeugt werden,
- man eine Betriebsstörung des in Betrieb genommenen elektronischen Bauteils entsprechend diesen Anregungen misst,
- man eine Kartografie der Empfindlichkeitsbereiche des Bauteils erstellt, in denen sich diese Anregungen auswirken,
- man auf die Kartografie der Empfindlichkeitsbereiche ein Programm zur Simulation einer Aggression durch ein Teilchen anwendet, das energetische Wechselwirkungen hervorruft,
- dieses Simulationsprogramm eine große Zahl an möglichen Verläufen der Teilchen im Bauteil erzeugt, sowie im Falle von Neutronen und Protonen eine große Zahl an Kernreaktionen, die aus einer Datenbank entnommen werden,
- dieses Simulationsprogramm ausgehend von diesen möglichen Verläufen und der Kartografie der Empfindlichkeit des Bauteils ein Modell zum Sammeln von Belastungen anwendet,
- dieses Simulationsprogramm diese Sammlungen von Belastungen analysiert und über das Vorkommen von Störungen in Verbindung mit diesen Belastungssammlungen entscheidet, und
- das Qualitätssignal des Bauteils aus dieser Analyse und diesen Zuständen abgeleitet wird,

wobei das Verfahren **dadurch gekennzeichnet ist, dass**:

- man im Falle von Neutronen und Protonen eine Datenbank verwendet, die über die Produkte und die Wahrscheinlichkeit möglicher Kernreaktionen Auskunft erteilt,
- man die Auswirkung der Ionisierung auf den Betrieb des elektronischen Bauteils misst,
- man bei Bauteilen mit einer feinen Integration mit der Laserkartografie eine maximale Größe des Empfindlichkeitsbereichs einer Einzelzelle misst, und
- das Simulationsprogramm Kernreaktionen aus einer Datenbank entsprechend dem Typ und der Energie des untersuchten Teilchens auswählt.

**2.** Verfahren nach Anspruch 1, **dadurch gekennzeichnet, dass**

- man auf die erstellte Laserkartografie eine Behandlung anwendet, um daraus eine Nutzkartografie zu extrahieren, die über die Empfindlichkeit des Bauteils gegenüber ionisierenden Teilchen Auskunft gibt.

**3.** Verfahren nach Anspruch 2, **dadurch gekennzeichnet, dass**

- man eine mathematische Dekonvolution durchführt, um eine Größe eines Lasereinflusses in Bezug auf eine geschätzte Größe eines Empfindlichkeitsbereichs des Bauteils gegenüber ionisierenden Teilchen zu berücksichtigen.

**4.** Verfahren nach einem der Ansprüche 1 bis 3, **dadurch gekennzeichnet, dass**

- man zur Quantifizierung der Empfindlichkeit des Bauteils mithilfe des Simulationsprogramms und entsprechend den festgelegten Kriterien für die untersuchte Funktionsstörung eine Reaktion des elektronischen Bauteils auf die Anregungen simuliert.

5. Verfahren nach einem der Ansprüche 1 bis 4, **dadurch gekennzeichnet, dass**

- man zum Erheben der energetischen Wechselwirkung durch Lasersimulation Wechselwirkungen zwischen schweren Ionen und/oder Protonen und/oder Neutronen misst.

6. Verfahren nach einem der Ansprüche 1 bis 5, **dadurch gekennzeichnet, dass**

- die Energie des Laserphotons der Laserquelle größer ist, als der Wert des verbotenen Bandes des Halbleiterbauteils.

7. Verfahren nach einem der Ansprüche 1 bis 6, **dadurch gekennzeichnet, dass**

- die Laserquelle eine gleichzeitige Absorption mehrerer Photonen im Halbleitermaterial bewirkt.

8. Verfahren nach einem der Ansprüche 1 bis 7, **dadurch gekennzeichnet, dass**

- die Laserkartografie gemäß den drei Dimensionen des Raumes erstellt wird.

9. Verfahren nach einem der Ansprüche 1 bis 8, **dadurch gekennzeichnet, dass**

- die Laserkartografie gemäß vier Dimensionen, den drei Dimensionen des Raumes und der Zeit erstellt wird.

**Claims**

1. Method for characterising the sensitivity to energetic interactions of an electronic component, wherein:

- the electronic component is put in operation,
- the electronic component is energised thus put into operation by the excitations produced by a laser beam,
- an operating fault of the electronic component put into operation is measured, corresponding to these excitations,
- a cartography of areas of sensitivity of the component where these excitations have an effect is established,
- a stress simulation programme by a particle provoking energetic interaction is applied to the cartography of areas of sensitivity,
- this simulation programme produces a large number of possible routes of the particles in the component, and for neutrons and protons, a large number of nuclear reactions extracted from a database,
- this simulation programme, based on these possible routes and the cartography of sensitivity of the component, implements a model of collection of charges,
- this simulation programme analyses these collections of charges and determines the occurrence of errors linked to these collections of charges, and
- the quality signal of the component is deduced from this analysis and from these positions,

the method being **characterised in that**:

- for neutrons and protons, a database informing about the products and probabilities of possible nuclear reactions is used,
- the effect of ionisation on the functioning of the electronic component is measured,
- for components with fine integration, a maximum size of sensitivity area of an elementary cell is measured with the laser cartography, and
- the simulation programme chooses nuclear reactions in a database corresponding to the type and to the energy of the particle studied.

2. Method according to claim 1, **characterised in that**:

- a treatment is applied to the established laser cartography to extract a useful cartography, this useful cartography taking into account the sensitivity of the component to ionised particles.

3. Method according to claim 2, **characterised in that**:

- a mathematic deconvolution is carried out to take into consideration a size of a laser impact compared to an estimated size of an area of sensitivity of the component in comparison with ionised particles.

4. Method according to one of claims 1 to 3, **characterised in that**:

- to quantify the sensitivity of the component, a response of the electronic component to excitations following determined criteria is simulated, using the simulation programme, for the dysfunction studied.

5. Method according to one of claims 1 to 4, **characterised in that**:

- as an energetic interaction measurement, the interactions of dense ions and/or protons and/or neutrons are measured by laser simulation.

6. Method according to one of claims 1 to 5, **characterised in that**:

   - the energy of the laser photon from the laser source is higher than the value of the forbidden band of the semi-conductor component.

7. Method according to one of claims 1 to 6, **characterised in that**:

   - the laser source provokes a simultaneous absorption of several photons of the semi-conductor material.

8. Method according to one of claims 1 to 7, **characterised in that**:

   - the laser cartography is carried out according to the three dimensions of space.

9. Method according to one of claims 1 to 8, **characterised in that**:

   - the laser cartography is carried out according to four dimensions, the three dimensions of space as well as time.

**Fig 1a**

**Fig 1b**

**Fig 1c**

**Fig 2**

A₁, Z₁, E₁

n/p

Si

A₂, Z₂, E₂

Tests laser

Base de données nucléaires

Topologie

Modèle simplifié des mécanismes physiques mis en jeu

Code Monte-Carlo

Courbes SRIM

**Fig 3**

Tirage d'une réaction nucléaire

Prédiction de la sensibilité

I(t)

I_max

t_Imax

**Fig 4a**

t

□ Simulation composant
△ Simulation SPICE

SEU

Pas de SEU

Imax seuil (mA)

**Fig 4b**

tmax (ps)

**EP 2 203 752 B1**

## RÉFÉRENCES CITÉES DANS LA DESCRIPTION

**Documents brevets cités dans la description**

- WO 2007119030 A

- EP 1231551 A

**Littérature non-brevet citée dans la description**

- **G. HUBERT.** A review of DASIE codes family : contribution to SEU/MBU understanding. *11th IEEE International On-Line Testing Symposium,* 2005